# EUROPEAN PATENT APPLICATION

(11) **EP 4 181 336 A1**
(43) Date of publication of application: **17.05.2023**
(21) Application number: 22205138.5
(22) Date of filing: 02.11.2022
(51) Int. Cl.: H02G 3/03, H02G 3/32, B60L 53/302, H02G 5/10

(54) **HEAT RETARDING ARRANGEMENT WITH A PHASE CHANGE MATERIAL FOR AN ELECTRIC VEHICLE**

(30) Priority: 10.11.2021 DE 102021129227
(71) Applicant: TE Connectivity Germany GmbH, 64625 Bensheim (DE)
(72) Inventor: SCHROTH, Lukas, 64625 Bensheim (DE); HAUCK, Uwe, 12347 Berlin (DE); LUDWIG, Michael, 64625 Bensheim (DE); EHEIM, Manuel, 64625 Bensheim (DE); WEBER, Alexander, 64625 Bensheim (DE); MUTH, Christopher, 64625 Bensheim (DE); SCHAEFER, Maik, 64625 Bensheim (DE); ECKEL, Markus, 64625 Bensheim (DE)
(74) Representative: Grünecker Patent- und Rechtsanwälte PartG mbB

(57) **Abstract**

The invention relates to a heat retarding arrangement (2) for an electric vehicle (5). According to the invention, in order to passively cool electric conductors in an electric vehicle, a heat retarding arrangement (2) for passively cooling an electric conductor (3, 4) is provided on or in an electric vehicle (5), wherein the heat retarding arrangement (2) comprises at least one phase change material (27) and is configured to be attachable to or in the electric conductor (4).

## Description

The invention relates to a heat retarding arrangement for passively cooling an electric conductor at or in an electric vehicle.

The invention moreover relates to arrangements which each comprise at least one heat retarding arrangement according to the invention.

In electric vehicles, in particular in their electric charge and/or drive circuits, and in connection arrangements, such as charging connectors, high currents can flow or should flow. High currents are here desired to permit a quick charging of the vehicle batteries or the provision of sufficient power for operating the vehicle. However, high currents usually lead to a heating of the electric conductors. This can be counteracted by an increase of the conductors' cross-sections. The increase of the conductors' cross-sections, however, is only practicable within certain limits. Larger conductor cross-sections mean an increased material consumption and thus increased costs. Moreover, increased conductor cross-sections of conductors on the vehicle side lead to an increased vehicle weight. This can in tum lead to a reduction of the range. Moreover, an active cooling for electric conductors is known. However, the active cooling systems need energy themselves and are moreover technically sophisticated and therefore expensive.

It is therefore the object of the invention to provide a solution by which electrical vehicles can be charged and/or operated with high currents without risking the overheating of an electric conductor.

This object is achieved by a heat retarding arrangement for passively cooling an electric conductor at or in an electric vehicle, wherein the heat retarding arrangement comprises at least one phase change material and is configured to be attachable at or in the electric conductor.

The phase change material can be configured such that a phase change, for example from the solid to the liquid or from the liquid to the gaseous phase, is accomplished when the temperature of the electric conductor reaches predetermined limits. Due to the phase change, a cooling of the phase change material, and thereby also of the electric conductor at or in which the heat retarding arrangement is disposed, is effected. The cooling achieved thereby can be sufficient to be able to maintain a certain intensity of current for an extended period. During a cooling of the phase change material, a reversed phase transition can take place so that the phase change material returns to its original state. The heat of the conductor is thereby intermediately stored or buffered. The heat retarding arrangement can be alternatively referred to as heating retarding arrangement or as thermal accumulator arrangement. The heat retarding arrangement can here operate according to the principle of a PCM device. The heat retarding arrangement can thus retard the heating of the electric conductor. By the solution according to the invention, an active cooling of the electric conductor can be omitted.

The solution according to the invention can be further improved by various embodiments which are each advantageous by themselves and can be combined with each other as desired. These embodiments and the advantages involved therewith will be discussed below.

The electric vehicle can be a battery-electric vehicle, a fuel-cell vehicle, or else a partially electrically operated vehicle, for example a hybrid vehicle or a plug-in hybrid vehicle.

The electric conductor can be part of a cable, for example a battery cable on the vehicle side, i. e. a cable which directly or indirectly connects a charging port on the vehicle side with an energy storage, in particular a battery. As an alternative, the conductor or the cable comprising the conductor can also be part of a high-voltage on-board power supply which, for example, connects the energy storage with the drive unit. Further examples of electric conductors are bus bars, contact elements and sections of contact elements, in particular contact elements in charging ports or charging pistols.

The heat retarding arrangement can be configured to be attachable at or in a conductor. Here, it can be directly or indirectly attached at the conductor. An indirect attachment can result from the heat retarding arrangement being attached, for example, at a cable that contains the electric conductor.

The heat retarding arrangement can be configured as a screw for interconnecting two electrical conductors. For example, the screw can be provided with phase change material, in particular inside a cavity formed in the screw.

The heat retarding arrangement can operate, in particular if it is attached in a conductor, according to the principle of a heat pipe. At a point where the heat retarding arrangement is heated, a phase transition, also referred to as phase shift or phase change, can take place for the phase change material as of a defined temperature, for example, from the solid state to the liquid state or from the liquid state to the gaseous state. In the process, thermal energy is withdrawn from the phase change material. At another point of the heat retarding arrangement, a reversed phase transition can take place. For example, the liquid phase change material can solidify again, or a gaseous phase change material can condense again and return to the liquid state. In the process, the thermal energy is released again. By a transport of the phase change material within the heat retarding arrangement, for example by capillary forces, the liquid phase change material can return again to the original place. Thereby, a heat retarding arrangement with a phase change material can be permanently operated passively as a cooling element or at least as a thermal conductor.

Due to the heat retarding or cooling effect of the heat retarding arrangement, it is preferably connected with those conductors or cables that probably heat up due to the current flow and where a heat development is not desired at least as of a certain degree. This can be the case in particular in cables where the heat development does not only lead to inefficient charging, but also to the charging current having to be reduced for safety reasons.

The phase change material can contain only, for example, paraffin and/or sodium. Other materials or combinations of materials are also possible.

The heat retarding arrangement can comprise a heat accumulator body with the phase change material. The heat accumulator body can in particular be a solid body. The heat accumulator body can comprise a cable receiving section for receiving the electric conductor, in particular the cable, and an abutment section configured for the abutment against a part of the vehicle. The heat accumulator body with the phase change material will be described below with reference to a heat retarding arrangement configured as a cable clip. The described embodiments of the heat accumulator body and their advantages, however, also apply to a heat accumulator body that is not part of a cable clip.

According to a particularly advantageous embodiment, the heat retarding arrangement is configured to be attached at a part of the vehicle. To this end, it can include, for example, an abutment section. The heat retarding arrangement can then not only buffer the heat of the conductor, but also discharge at least a portion of the heat to the vehicle by forwarding the heat to the part of the vehicle where it is attached. The vehicle can thus serve as a heat sink.

In particular, the heat retarding arrangement can be configured as a cable clip for fastening at least one cable to an electric vehicle, wherein the cable clip comprises a cable receiving section configured to receive the at least one cable and an abutment section configured for the abutment against a part of the vehicle, and wherein the cable clip furthermore comprises at least one heat accumulator body with the phase change material which is configured to conduct heat from the cable receiving section to the abutment section, in particular by means of the phase change material. The mentioned cable can comprise an electric conductor.

The cable clip initially serves to fasten the at least one cable to a part of the vehicle. Here, the cable clip can abut against a part of the vehicle with its abutment section. An unintentional movement of the cable can thus be effectively prevented. By the heat accumulator body, , additional mass is moreover admitted to a cable received in the cable clip by which vibrations in the cable can be attenuated. A particular advantage of the cable clip is, in addition to the above-mentioned advantages, the heat accumulator and heat conducting properties of the heat accumulator body with the phase change material. By means of this heat accumulator body, heat can be dissipated from the cable in a retarded manner and even very quickly. The at least one cable can therefore be cooled by the at least one cable clip. Therefore, the cable clip is a heat retarding or cooling cable clip.

The thermal energy received by the cable can be conducted via the abutment section into the part of the vehicle where the cable clip abuts with its abutment section. The vehicle can thus serve as a heat sink.

The heat accumulator body with the phase change material can operate according to the principle of a PCM device. The phase change material can here be embedded in the heat accumulator body or be enclosed in the heat accumulator body in separated spaces. By the phase transitions of the phase change material, even in such an embodiment, a good heat conduction can be achieved by the heat accumulator body. The principle of the PCM device is not only advantageous for cooling a cable received in the cable receiving section by a phase transition of the phase change material from solid to liquid or liquid to gaseous, but also offers altogether a good heat conduction and can conduct heat from the cable receiving section to the abutment section.

The heat accumulator body with the phase change material can moreover operate according to the principle of a heat pipe. At a point where the heat accumulator body is heated, that is in case of a cable clip at the cable receiving section, a phase transition, also referred to as phase shift or phase change, can take place for the phase change material contained in the heat accumulator body as of a defined temperature, for example, from the solid state to the liquid state or from the liquid state to the gaseous state. In the process, thermal energy is withdrawn from the heat accumulator body at this point.

At another point of the heat accumulator body, a reversed phase transition can take place. For example, the liquid phase change material can solidify again, or a gaseous phase change material can condense again and return to the liquid state. In the process, the thermal energy is released again. By a transport of the phase change material within the heat accumulator body, for example by capillary forces, the liquid phase change material can return again to the original place. Thereby, a heat accumulator body with a phase change material can be permanently operated passively as a cooling element or at least as a thermal conductor.

The temperatures at which the phase transitions take place can be defined by a suited material selection of the material for the heat accumulator body and for the phase change material and by the pressure prevailing inside the heat accumulator body. In case of a phase change material which undergoes, during the operation of the cable clip, phase transitions from the solid to the liquid phase and vice versa, the condensation of the phase change material is preferably effected near the cable receiving section, and the solidification near the abutment section. In case of a phase change material which undergoes, during the operation of the cable clip, phase transitions from the liquid to the gaseous phase and vice versa, evaporation is correspondingly effected near the cable receiving section, and condensation near the abutment section.

By the embodiment as a heat pipe, the heat is therefore not only retarded but also carried off from the place where it arises.

The part of the vehicle to which the heat retarding arrangement, in particular the cable clip, can be attached can be part of the chassis, the car body, the drive, a battery housing, or another component. The attachment to a battery housing can be advantageous since batteries or their housings often have a cooling system themselves in electric vehicles. Therefore, the heat arising in the cable can be supplied to the cooled battery housing via the heat retarding arrangement.

To achieve a large-surface abutment of the abutment section at the part of the vehicle, an abutment surface of the abutment section can substantially be as large as a cross-section of the heat accumulator body. In other words, the cross-section of the heat accumulator body extends continuously into the abutment section. Thereby, an efficient dissipation of the heat from the heat accumulator body into the vehicle can be accomplished.

The heat accumulator body preferably has spaces in which the phase change material is embedded. The heat accumulator body can have, for example, a frame structure. In order to obtain a frame structure, the heat accumulator body can be made, for example, of foamed material whose pores form the spaces and contain phase change material. The spaces can be dimensioned such that a sufficiently good flow of phase change material, for example by capillary forces, is possible. The spaces can alternatively be formed as channels in the heat accumulator body.

To facilitate the assembly of the heat retarding arrangement, in particular a cable clip, around a cable provided for being received in the cable receiving section, the heat accumulator body preferably has a two-piece design, the cable receiving section being located between the two parts of the heat accumulator body. For example, the two parts of the heat accumulator body can each form a half bowl that can close around a cable.

To ensure and improve the heat transfer to the vehicle in a state attached to the vehicle, the heat retarding arrangement can include at least one heat conducting element at its abutment section. The at least one heat conducting element is preferably deformable plastically and/or elastically. The heat conducting element can, for example, be a heat conducting pad, a layer of heat conducting adhesive, or a layer of heat conducting paste. The at least one heat conducting element can serve to fill small gaps between the heat retarding arrangement and the vehicle.

The heat conducting element can be located, in a state mounted to the vehicle, between the part of the vehicle where the heat retarding arrangement is attached, in particular the cable clip, and the heat accumulator body, or between this part of the vehicle and the housing of the heat retarding arrangement, depending on whether the housing, if provided, is open towards the abutment section.

Equally, the heat accumulator body can be provided at the cable receiving section with at least one heat conducting element, for example a heat conducting pad, a layer of heat conducting adhesive, or a layer of heat conducting paste, whereby the heat transfer between a cable arranged in the cable receiving section and the heat accumulator body can be improved. This can be accomplished, for example, in that the heat conducting element fills gaps between the cable and the heat accumulator body, and at those locations where a heat insulating layer of air would be present otherwise, permits the heat transfer between the cable and the heat accumulator body. The heat conducting element is preferably deformable plastically and/or elastically.

In order to obtain a stable structure, the heat retarding arrangement, in particular a heat retarding arrangement configured as a cable clip, preferably moreover comprises at least one housing in which the phase change material, in particular a heat accumulator body containing the phase change material, is accomodated. The at least one housing can also be used for receiving and keeping together a two- or multi-piece heat accumulator body.

At an abutment section, the housing can be opened such that a heat accumulator body accommodated therein is exposed. Thereby, the heat accumulator body can directly abut against the part of the vehicle when the heat retarding arrangement is fixed thereto.

As an alternative, the housing can also be closed, also in the region of the abutment section if it is provided. A closed housing can be advantageous if the heat retarding arrangement does not comprise a solid heat accumulator body and if it has to be ensured that liquid or gaseous phase change material does not leak.

The at least one housing is preferably made of a plastic or metal. As an alternative, other materials, for example, composite materials, ceramics, silicone containing materials or others, are also possible.

A housing of plastic has the advantage that the housing can be manufactured quickly and inexpensively. A housing of metal has the advantage that, depending on the metal, it intrinsically has a high thermal conductivity and can thereby contribute to heat conduction and also to the dissipation of heat to the surrounding area. A metallic housing is preferably formed of a light metal or a light metal alloy. In a particularly preferred manner, the housing is formed of aluminum or an aluminum alloy.

According to a further advantageous embodiment, the housing can be expandable in a rubbery-elastic manner. This can be the case, for example, if the housing consists of silicone material. A housing expandable in a rubbery-elastic manner can expand or contract to follow a volume change of the phase change material during a phase transition. It can be prevented thereby that an excess or negative pressure arises in the housing by which the housing becomes leaky. Another advantage of a rubbery-elastic housing is the increased overall volume of the phase change material that can be accommodated.

In particular, a rubbery-elastic housing can be configured as a pad which can abut against the electric conductor. The housing can include the phase change material in its interior.

A further preferred embodiment can be obtained by a housing, in particular a rubbery-elastic housing which can tightly seal a receptacle in the electric conductor. The housing can form a common cavity together with the receptacle in the electric conductor in which the phase change material is accommodated. The housing can be formed as a cap for closing the receptacle.

The heat retarding arrangement can be provided with at least one passive cooling structure, in particular with at least one cooling fin. The cooling fin can preferably be formed at the housing. The latter can be the case in particular in a housing of a metal, for example, aluminum. The at least one cooling structure can dissipate heat to the surrounding area, in particular to the surrounding air, whereby the cooling by the heat retarding arrangement can be further improved.

According to a particularly advantageous embodiment, the at least one cooling structure can be formed at the heat accumulator body, wherein the housing includes a cavity in which the cooling structure is accommodated. As an alternative, the housing can be open in the region of the cooling structure at the heat accumulator body to have the cooling structure project to the outside.

To be able to simply fasten the heat retarding arrangement, in particular a heat retarding arrangement configured as a cable clip, at the part of the vehicle, the housing can be provided with at least one fastening element for fastening the heat retarding arrangement at the vehicle, in particular with a flange. The fastening element can be configured to fasten the heat retarding arrangement to the vehicle, for example by means of a threaded joint, a locking, or an adhesive joint. In case of a flange, this can be provided, for example, with passage bores through which complementary fastening elements of the vehicle can extend.

The housing can be provided with at least one, in particular interior, locking element for mounting the heat accumulator body, at least during assembly. Thereby, the assembly of the heat retarding arrangement, in particular of a heat retarding arrangement configured as a cable clip, can be facilitated. The at least one heat accumulator body can be formed complimentarily to the mentioned locking elements. For example, the housing can be formed with a locking element configured as a locking hook, and the heat accumulator body can be formed with at least one receptacle for the locking hook. When the heat accumulator body is inserted into the housing, the locking hook can be received in the receptacle and lock the heat accumulator body in the housing.

An embodiment with at least one locking element for mounting the heat accumulator body in particular makes sense if the heat accumulator body is made of multiple pieces. For example, a first part of the heat accumulator body can be inserted into the housing, subsequently, the conductor, in particular a cable, can be inserted, and finally, the second part of the heat accumulator body can be set into the housing. Of course, the second part of the heat accumulator body can also be locked with the housing via a corresponding locking connection. As an alternative to the above-mentioned embodiment, the heat accumulator body can be provided with a locking projection, and the housing can be provided with a corresponding receptacle for the projection.

According to a further advantageous embodiment of the heat retarding arrangement, the latter can furthermore comprise at least one temperature sensor. In particular, a temperature sensor embedded in a heat accumulator body, if provided. Thereby, the temperature of the phase change material, in particular the heat accumulator body, can be monitored and transmitted to a control unit, in particular a control unit configured to control a charging current.

In a particularly preferred manner, an inventive arrangement comprises an inventive heat retarding arrangement and at least one control unit connected with the at least one temperature sensor in a data transmitting manner and configured to control a current flow through the conductor, in particular through a cable comprising the conductor. The control unit can monitor the temperature and in particular the temperature change of the phase change material.

In a particularly preferred manner, the control unit is connected with a storage unit which stores at which temperatures a phase transition takes place in the phase change material or in a heat accumulator body including the phase change material. On the basis of the knowledge of an imminent phase transition, the control unit can control the charging current. Since thermal energy is dissipated during the first phase transition, for example from solid to liquid or liquid to gaseous, the charging current can be correspondingly high since the overheating of the conductor or other components of the vehicle can still be prevented.

In a particularly preferred manner, the heat retarding arrangement, in particular its heat accumulator body, is provided with at least two temperature sensors which are arranged spaced apart within the heat accumulator body. By this arrangement, the heat flow within the heat accumulator body can be determined. Thereby, an even more precise knowledge of the condition of the heat accumulator body or the phase change material contained therein can be gained. Consequently, one can even more precisely determine when a phase transition takes place and how high the current flow in the conductor may be. The control unit can then correspondingly set the current flow through the conductor. By this embodiment, the maximally possible charging current during the charging of an electric vehicle can be predicted by calculation and exhausted without reaching a dangerous temperature trail above admissible limits and thus risking to overheat the conductor and components connected therewith.

A further arrangement according to the invention comprises a heat retarding arrangement configured as a cable clip and at least one cable received in the cable receiving section of the cable clip, wherein the at least one cable comprises an inner conductor as the electric conductor, an inner insulation surrounding the inner conductor, a shield surrounding the inner insulation, and an outer insulation surrounding the shield, wherein the shield is exposed in a section of the cable and the heat accumulator body of the cable clip abuts against the shield in this section. The heat accumulator body can then directly abut against the shield of the cable. Thereby, not only the heat transfer can be improved, but the cable clip can also be used for electromagnetic shielding and interference suppression. The latter can be improved by the heat accumulator body itself consisting of an electrically conductive material, or being at least coated with it at least in sections. It is moreover possible to embed an anti-interference element, for example a ferrite core, into the heat accumulator body which improves the electromagnetic shielding and interference suppression of the cable.

A further advantageous arrangement in the sense of the invention comprises a heat retarding arrangement, in particular a heat retarding arrangement configured as a cable clip, a charging port on the vehicle side and at least one cable connected with the charging port. The heat retarding arrangement is here preferably attached to the cable at a distance of less than 20 cm, particularly preferred less than 10 cm, to the charging port. If the heat retarding arrangement is configured as a cable clip, the cable is preferably received in the cable receiving section of the cable clip. The arrangement of the cable clip near the charging port can be advantageous to dissipate heat from the charging port via the cable and the cable clip. Thereby, the cable clip at the cable can indirectly cool the contacts in the charging port.

A further arrangement according to the invention comprises a heat retarding arrangement configured as a cable clip and a part of a vehicle, wherein the part of the vehicle can also be the vehicle itself, wherein the cable clip is fixed to the part of the vehicle and abuts against the part of the vehicle with its abutment section, and wherein at least one cable of the vehicle is received in the cable receiving section.

According to another aspect of the present invention and as an alternative to a cable clip that is attachable to a cable, a heat transfer arrangement is provided that is configured as part of a fixation structure for fixating a bus bar to the vehicle or another solid structure.

The heat transfer arrangement may comprise an adapter between the bus bar and the vehicle and/or a hold down device for fixating the bus bar to the vehicle.

Furthermore, the heat transfer arrangement may comprise an intermediate layer between the bus bar and the vehicle, between the bus bar and the adapter or between the bus bar and the hold down device. The intermediate layer is preferably a foil that is wrapped around the bus bar. In the alternative, the intermediate layer may be a plate or a coating on the bus bar.

The heat transfer arrangement for fixating the bus bar to the vehicle does not necessarily need to comprise a phase change material. However, any one of the adapter, the hold down device and the intermediate layer may comprise a phase change material or may be made of a phase change material.

In an assembled state, the bus bar may be arranged between a part of the vehicle and the hold down device. The intermediate layer may at least be arranged between the bus bar and the part of the vehicle.

If an adapter is used, the adapter may be arranged between the bus bar and the part of the vehicle. If also an intermediate layer is present, this intermediate layer is preferably arranged between the bus bar and the adapter.

The adapter and/or the hold down device may be provided with at least one cavity filled with phase change material.

The adapter may be provided with at least one cooling channel for coolant of a cooling circuit.

The heat transfer arrangement may be a heat retarding arrangement according to the invention. In particular, a section of the heat transfer arrangement, which is in contact with the vehicle, can be regarded as the abutment section of the arrangement.

A section of the heat transfer arrangement, which is in contact with the bus bar may correspond to the cable receiving section of the cable clip. If an element of the heat transfer arrangement contains phase change material, then this element may be regarded as the heat accumulator body.

The improvements of the invention that are described in relation to the cable clip can also be applied to the heat transfer arrangement described above.

The invention will be illustrated more in detail below by way of example by an advantageous embodiment with reference to the drawings. The combination of features represented by way of example in the embodiment can be supplemented by further features according to the above illustrations corresponding to the properties of the heat retarding arrangement according to the invention for a certain case of application. Moreover, also according to the above illustrations, individual features can be omitted in the described embodiment if the effect of this feature is not relevant in a concrete case of application. In the drawings, the same reference numerals are always used for elements having the same function and/or the same structure.

### In the drawings:

- Fig. 1: shows a first exemplary embodiment of a heat retarding arrangement according to the invention configured as a cable clip at a cable in a perspective representation;
- Fig. 2: shows a section through the embodiment of the cable clip of Fig. 1;
- Fig. 3: shows the cable clip of Fig. 1 with a viewing direction onto the abutment section;
- Fig. 4: shows a section through a cable clip represented by way of example, and through a cable;
- Fig. 5: shows a section through a further cable clip represented by way of example, and through a cable;
- Fig. 6: shows a further embodiment represented by way of example of a heat retarding arrangement configured as a cable clip with temperature sensors;
- Fig. 7: shows an arrangement according to the invention with heat retarding arrangements according to the invention;
- Fig. 8: shows an embodiment represented by way of example of a heat retarding arrangement according to the invention in a charging port;
- Fig. 9: shows a further embodiment represented by way of example of a heat retarding arrangement according to the invention in a charging port;
- Fig. 10: shows an embodiment represented by way of example of a heat retarding arrangement according to the invention at an electric conductor;
- Figs. 11-13: show an embodiment represented by way of example of a heat retarding arrangement according to the invention in a screw of a bolted connection;
- Figs. 14 & 15: show a first embodiment represented by way of example of a heat transfer arrangement for fixating a bus bar to a vehicle;
- Figs 16 & 17: show a second embodiment represented by way of example of a heat transfer arrangement for fixating a bus bar to a vehicle; and
- Figs 18 - 20: show a third embodiment represented by way of example of a heat transfer arrangement for fixating a bus bar to a vehicle.

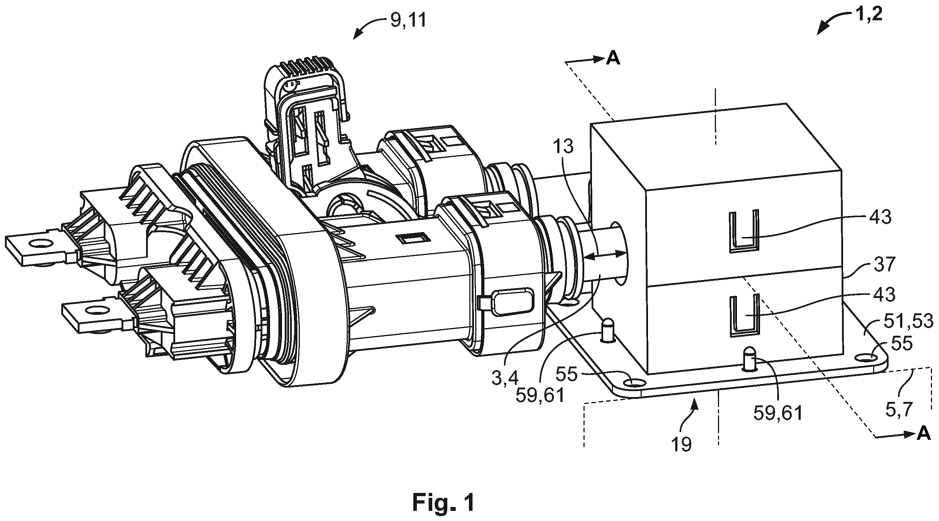

Below, a first advantageous embodiment of a heat retarding arrangement 2 configured as a cable clip 1 is described with reference to Figures 1 to 3.

The cable clip 1 serves to fasten a cable 3 comprising an electric conductor 4 to an electric vehicle 5 or a part 7 of an electric vehicle 5. The electric vehicle 5 or the part 7 of the vehicle 5 are only indicated in a dashed line in Fig. 1. The part 7 can be, for example, a part of the chassis, the car body, the drive, a battery housing, or another vehicle component. The electric conductor 4 can be, for example, an inner conductor of the cable 3.

The cable clip 1 for fastening exactly one cable 3 is also represented only by way of example. As an alternative, the cable clip 1 can also be configured to simultaneously fasten a plurality of cables 3.

The cable clip 1 is preferably arranged near a component 9 that is connected with the cable 3. The component 9 can be a pin-and-socket connector 11, as represented by way of example. As an alternative, other components 9 are also conceivable, in particular a charging port on the vehicle side, a drive unit, a battery or accumulator of the vehicle, a controller or other things.

Preferably, a distance 13 of the cable clip 1 to the component 9 amounts to only a few centimeters, particularly preferred less than 10 cm. Thereby, heat developed in the component 9 can be conducted via the cable 3 into the cable clip 1 and through the latter to the vehicle 5.

The cable 1 has a cable receiving section 15 configured to receive the cable 3. The cable receiving section 15 can include a passage opening 17 through which the cable 3 can be guided.

The cable clip 1 moreover includes an abutment section 19 configured for the abutment against a part 7 of the vehicle 5. The cable clip 1 is formed in the abutment section 19 which can represent one end of the cable clip 1, preferably complementary to the part 7 of the vehicle 5 where the cable clip 1 is to be attached.

In the embodiment represented by way of example, the cable clip 1 is flatly configured in the abutment section 19. This means it can be used for the abutment against a plane surface. As an alternative, other embodiments are also possible.

The flat design has the advantage that heat from the cable clip 1 can be conducted to the vehicle 5 over a large abutment surface. The abutment surface 21 in the abutment section 19 preferably substantially corresponds to the cross-sectional area 23 of the cable clip 1. In other words, the cross-section of the cable clip 1 can continuously extend into the abutment section 19.

The cable clip 1 comprises a heat accumulator body 25 with a phase change material 27. The phase change material 27 is located within the heat accumulator body 25. The heat accumulator body is preferably provided with spaces 29 or cavities 29 in which the phase change material 27 is located. The spaces 29 can extend continuously through the heat accumulator body 25 or be locally limited.

Preferably, the heat accumulator body 25 is formed of a material which includes a frame structure 31. The frame structure 31 can span the spaces 29. A frame structure 31 can be formed, for example, from a foamed material.

As an alternative, channels as spaces 29 in which the phase change material 27 is located can also pass through the heat accumulator body. A further alternative can be that the heat accumulator body 25 consists of a composite material which contains the phase change material 27 as a component.

The heat accumulator body 25 preferably has a multi-piece design, in particular a two-piece design. Preferably, the heat accumulator body 25 includes two half bowls 33 and 35 which can be arranged one lying against the other. Between the half bowls 33 and 35, there is the cable receiving section 15 with the passage opening 17.

In particular in an embodiment with a multi-piece heat accumulator body 25, the cable clip 1 can comprise a housing 37 in which the heat accumulator body 25 is accommodated. The housing 37 can be formed of a plastic, a metal, in particular aluminum, or another material. A further alternative can naturally be that the cable clip 1 is formed without housing 37.

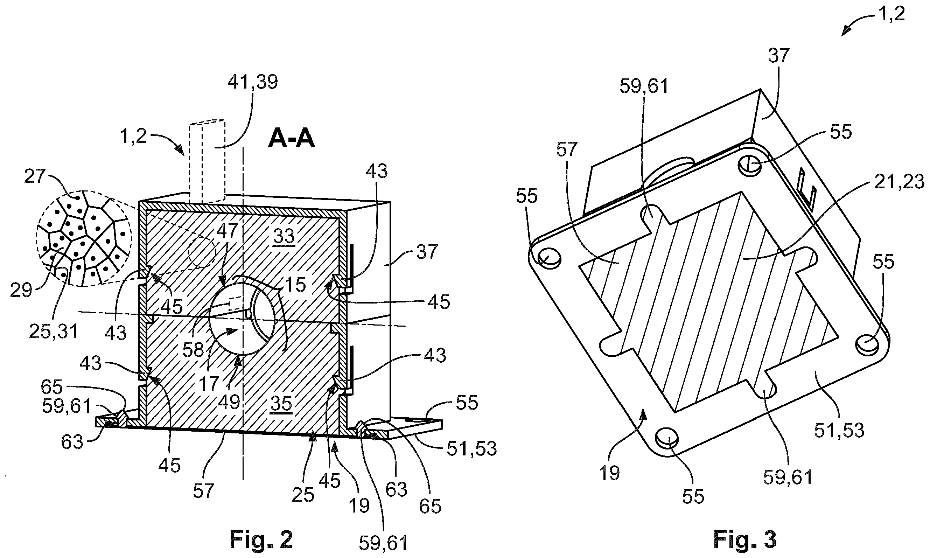

The housing 37 can be provided with at least one passive cooling structure 39 (indicated in a dashed line in Fig. 2), in particular with a cooling fin 41. As an alternative, the at least one passive cooling structure 39 can also be part of the heat accumulator body 25. The housing 37 can then extend around this cooling structure or expose it.

To securely fasten the two parts, or the half bowls 33 and 35 of the heat accumulator body 25, the housing 37 preferably includes a plurality of locking elements configured as locking hooks 43 which can engage with locking recesses 45 in the half bowls 33 and 35 configured complementarily to it, and can secure them in the housing 37.

For example, initially, the half bowl 33 can be inserted into the housing 37 to such an extent that the locking hooks 43 are arranged in the locking recesses 45. Subsequently, the cable 3 can be inserted so that it is arranged in the cable receiving section 15. Finally, the second half bowl 35 can be inserted. Since both half bowls 33 and 35 are each provided with a conduit-like recess 47 or 49, respectively, which together form the passage opening 17 in an assembled state, the cable 3 is held between both half bowls 33 and 35 in the cable clip 1 in the assembled state.

To fasten the cable clip 1 at the vehicle 5, and thereby indirectly fasten the cable 3 at the vehicle 5, the cable clip is preferably provided with at least one fastening element 51. In the embodiment represented by way of example, the fastening element 51 is a flange 53.

The flange 53 is provided with a plurality of passage bores 55. Fastening parts, for example screws or clips, can be guided through them to hold the cable clip 1 at the vehicle 5.

To improve the heat conduction between the heat accumulator body 25 and the vehicle 5, or to ensure a continuous abutment of the cable clip 1 at the vehicle 5, the cable clip 1 preferably includes a heat conducting element 57 which is preferably arranged at the abutment section 19. The heat conducting element 57 can be a heat conducting pad, a layer of heat conducting adhesive, a layer of heat conducting paste, or another suited element.

The housing 37 can be opened in the abutment section 19 to have the heat accumulator body 25 abut directly or, via the heat conducting element 57 indirectly, against the vehicle 5. As an alternative, the housing 25 can also be closed in the abutment section 19. This can be the case, for example, with a housing 37 of a metal. If the cable clip 1 is provided with a heat conducting element 57, it can be arranged outside at the housing 37 at the abutment section 19.

The heat conducting element 57 is preferably deformable plastically and/or elastically. Thereby, during assembly, it can be pressed into spaces between the cable clip 1 and the part 7 of the vehicle 5 where the cable clip 1 abuts, and seal these spaces in a heat conducting manner.

To fasten a heat conducting element 57, it can include, for example, fastening elements 59 projecting towards the cable receiving section 15, for example elastically deformable locking hooks 61 which project through passage openings 63 in the housing 37, in particular in the flange 53, and are secured against slipping out by a thickened end 65. As an alternative, the heat conducting element 57 can also be glued onto the rest of the cable clip 1, or be fastened thereto in another suited manner.

At least one further heat conducting element 58 (indicated in a dashed line in Fig. 2) can be arranged in the cable receiving section 15 to contribute to the heat conduction between a cable 3 in the cable receiving section 15 and the heat accumulator body 25.

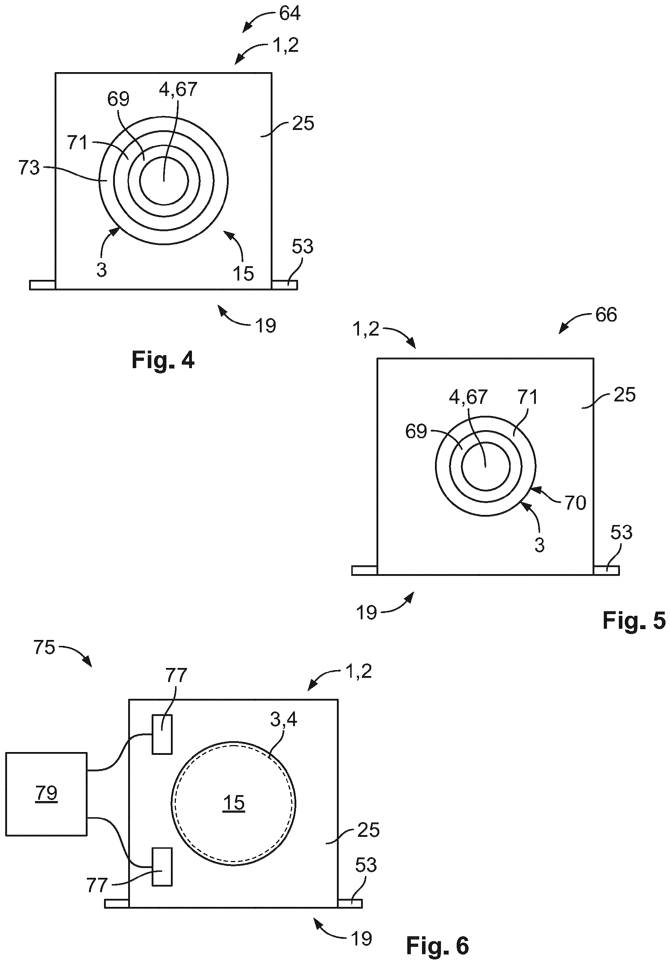

Below, reference is made to Fig. 4. In Fig. 4, a heat retarding arrangement 2 configured as a cable clip 1 is only indicated, wherein the cable clip 1 can in particular correspond to the embodiment described with reference to Figures 1 to 3.

The cable clip 1 and the cable 3 together form an arrangement 64. The representation shows a section which corresponds to the sectional axis marked with A-A in Fig. 1. A cable 3 is also shown in a sectional representation.

The cable 3 has an inner conductor 67, an inner insulation 69 surrounding the inner conductor 67, a shield 71 surrounding the inner insulation 69, and an outer insulation 73 surrounding the shield 71. In this embodiment, the heat accumulator body 25 abuts against the outer insulation 73.

This embodiment is advantageous because no changes have to be made to the cable 3. This can facilitate the assembly of the cable clip 1. However, the fact that heat generated in the inner conductor 67 has to pass through a plurality of layers of the cable 3 before it reaches the heat accumulator body 25 can here also have a negative effect.

An alternative embodiment of an arrangement comprising a cable clip 1 and a cable 3 will be described below with reference to Fig. 5. To keep the description short, only the differences to the embodiment described with reference to Fig. 4 will be discussed.

In the arrangement 66, the cable 3 does not have any outer insulation 73, at least in the section 70 where it passes through the cable clip 1. Preferably, it substantially is a cable 3 as described with reference to Fig. 4, however, the outer insulation 73 is removed in the section 70 where it extends through the cable clip 1. The heat accumulator body 25 of the cable clip 1 consequently directly abuts against the shield 71.

This arrangement permits a better heat conduction from the inner conductor 67 into the heat accumulator body 25 since the outer insulation 73 is missing. Moreover, the heat accumulator body 25 in direct contact with the shield 71 can contribute to the electromagnetic shielding and interference suppression, in particular if the heat accumulator body 25 is formed of a suited material, in particular an electrically conductive one.

The arrangement 66 can, as an alternative to the above-described embodiment, comprise a heat retarding arrangement 2 which is not configured as a cable clip 1, instead of the cable clip 1.

Below, a further advantageous embodiment of a cable clip 1 and a further advantageous arrangement 75 will be briefly discussed. The cable clip 1 can be structured as the cable clips 1 described above. The arrangement 75, too, can, as an alternative to the cable clip 1, comprise a heat retarding arrangement 2 which is not configured as a cable clip 1.

The difference to the above-described embodiments of the cable clip 1 is that the heat accumulator body is provided with two temperature sensors 77 which are embedded in the material of the heat accumulator body 25 spaced apart from each other. Both temperature sensors 75 are connected with a control unit 79 in a data transmitting manner. The cable clip 1 forms the arrangement 75 together with the control unit 79.

The control unit 79 can be configured to control a current flow through a cable 3 arranged in the cable receiving section (only represented in a dashed line in Fig. 6). By means of the data received from the temperature sensors 77, the temperature flow within the heat accumulator body 25 can be determined. In particular, a difference measurement of the temperatures through the two sensors 77 can be performed.

By means of the data obtained from the temperature sensors 77, it can be possible to predict a phase transition of the phase change material 27 located in the heat accumulator body 25 and to correspondingly adjust the current flow through the cable 3. If such a calculation shows, for example, that the temperature in the heat accumulator body 25 has not yet reached a phase transition temperature, one can do without reducing the current flow through the cable, or the current flow through the cable 3 can even be increased because it is known that the phase transition in the phase change material 27 has a cooling effect on the heat accumulator body 25 and thus indirectly on the cable 3.

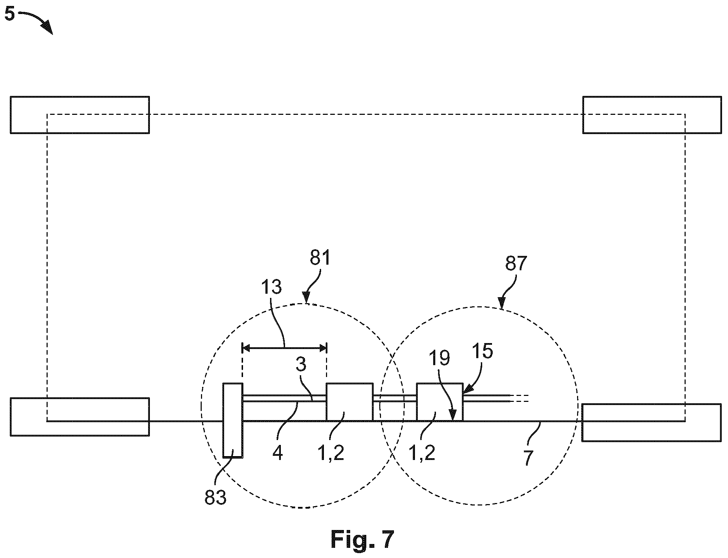

Below, two further advantageous arrangements each comprising a heat retarding arrangement 2 configured as a cable clip 1 will be briefly described with reference to Fig. 7. Fig. 7 schematically shows a vehicle 5 from above.

An arrangement 81 comprises a charging port 83 on the vehicle side, a cable 3, and a cable clip 1. The charging port 83 is here a further example of a component 9. The cable 3 as a battery cable can connect, for example, the charging port 83 with traction batteries.

The charging port 83 can extend from a region outside a vehicle 5 into the interior of the vehicle 5. The cable 3 is connected to the charging port 83 in a current-transmitting manner. A cable clip 1 which is to connect the cable 3 with a part 7 of the vehicle 5 is preferably arranged at a distance 13 to the charging port 83 which is preferably less than 10 cm. In this manner, the cable clip 1 can indirectly remove heat from the charging port 83 via the cable 3. As part 7 of the vehicle, the car body is represented only by way of example. Of course, the cable clip 1 can also be attached to any other interior part of the vehicle 5.

A further cable clip 1 by which the cable 3 is fastened to the vehicle 5 is also represented only by way of example. The vehicle 5 can be provided with any number of cable clips 1 to secure the cable 3 sufficiently against movements, in particular vibrations, and to dissipate heat from the cable 3.

A further arrangement 87 represented in Fig. 7 comprises a heat retarding arrangement 2 configured as a cable clip 1, a part 7 of the vehicle 5, optionally the complete vehicle 5, and the cable 3, wherein the cable 3 is received in the cable receiving section 15 of the cable clip 1 and the cable clip 1 abuts against the part 7 of the vehicle 5 with its abutment section 19.

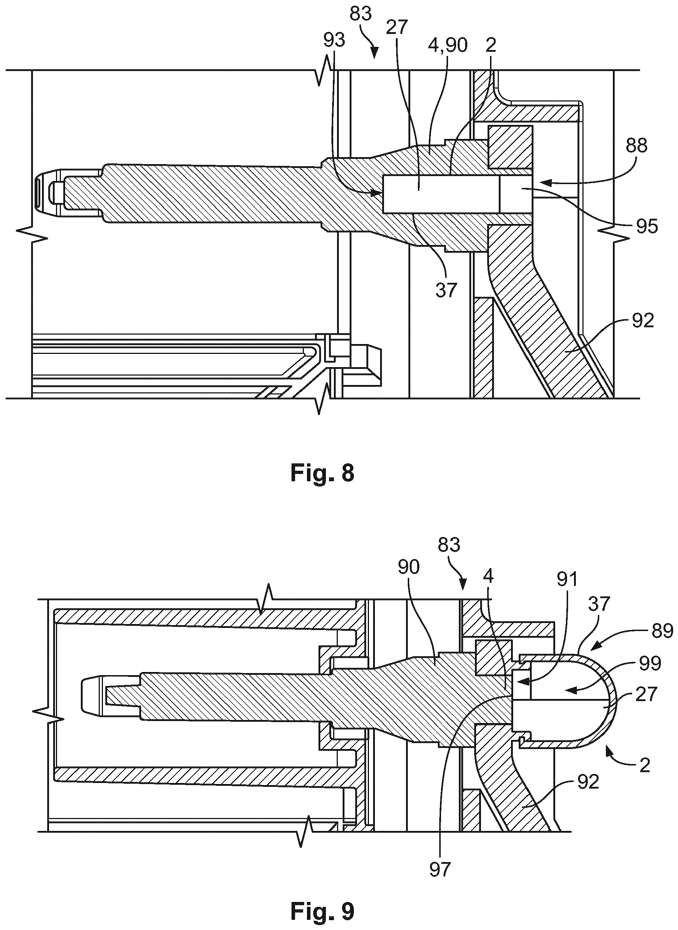

In Fig. 8, an arrangement 88 is shown wherein a heat retarding arrangement 2 according to the invention is arranged in an electric conductor 4. The electric conductor 4 is a contact element 90 which can be part of a charging port 83 of the vehicle 5. The contact element 90 is connected with a bus bar 92 in an electrically conductive manner so that the contact element 90 and the bus bar 92 together form an electric conductor 4.

There is a cavity 93 in the contact element 90 in which the heat retarding arrangement 2 is accommodated.

In the simplest case, the heat retarding arrangement 2 only comprises the phase change material 27 in this arrangement. The phase change material 27 can be, for example, filled or placed in the cavity 93, and the cavity 93 can be subsequently sealed. To this end, one end of the cavity 93 that is originally open to the outside can be sealed to the outside with a cap 95.

As an alternative, the heat retarding arrangement 2 can also include a housing 37 in which the phase change material 27 is accommodated. The heat retarding arrangement 2 with the housing 37 can be formed, for example, as an insert for the cavity 93. For assembly, the heat retarding arrangement 2 can be pushed, for example, into the cavity 93.

Below, Fig. 9 will be briefly discussed. Here, too, a heat retarding arrangement 2 according to the invention is used for passively cooling a contact element 90 of a charging port 83.

The heat retarding arrangement 2 comprises the phase change material 27 and a rubbery-elastic housing 37. The electric conductor 4, consisting of the bus bar 92 and the contact element 90, is provided with a receptacle 91. The phase change material 27 is received partially within the receptacle 91 and partially within the housing 37.

A wall 97 in the electric conductor 4 defining the receptacle 91 and the housing 37 form a common cavity 99 in which the phase change material 27 is accommodated.

Due to the rubbery-elastic design of the housing 37, the housing 37 can compensate volume changes of the phase change material 27. Volume changes can in particular be caused by the phase transitions in the phase change material.

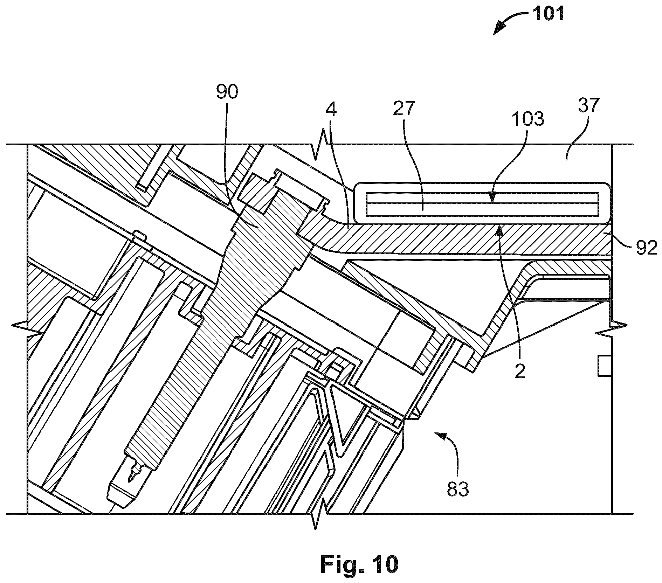

Below, Fig. 10 will be discussed in which a further arrangement 101 with a heat retarding arrangement 2 according to the invention is represented.

The arrangement 101 also comprises a contact element 90 of a charging port 83, wherein the contact element 90 is connected with a bus bar 92 in an electrically conductive manner. The heat retarding arrangement 2 according to the invention is here arranged to abut against the bus bar 92 and does not necessarily contact the contact element 90.

The arrangement at the bus bar 92 can facilitate assembly and/or make sense if there is not sufficient installation space at the contact element 90. By the contact element 90 being electrically conductively connected with the bus bar 92, depending on the selection of the employed conductive materials, it is usually also connected with the bus bar 92 in a heat conducting manner. Heat generated in the contact element 90 can therefore be conducted to the heat retarding arrangement 2 via the bus bar 92. The heat retarding arrangement 2 is here preferably arranged on the bus bar 92 at a small distance to the contact element 90. The distance preferably is only a few centimeters, particularly preferred maximally 10 cm.

The heat retarding arrangement 2 of this embodiment preferably also has a rubbery-elastic housing 37. In contrast to the embodiment described with reference to Fig. 9, the housing 37 is here, however, closed all around. The heat retarding arrangement can be considered as a kind of pad which can be attached to the bus bar 92.

The housing 37 has an inner space 103 in which the phase change material 27 is accommodated. As in the embodiment described with reference to Fig. 9, the rubbery-elasticity of the housing 37 can absorb volume changes of the phase change material 27.

The heat retarding arrangement 2 can be, for example, glued to the bus bar 92. Preferably, with a heat-conducting adhesive. As an alternative or in addition, the heat retarding arrangement 2 can be held at the bus bar 92 by suited external fastening means, for example locking elements or tie wraps.

In particular in case of the fastening by external fastening means, between the heat retarding arrangement 2 and the bus bar 92, at least one heat conducting element (not shown here) can be arranged between the bus bar 92 and the heat retarding arrangement 2 for a better heat transfer. The heat conducting element can in particular be a layer of heat conducting paste or a heat conducting pad. The above-mentioned heat conducting adhesive is also considered as heat conducting element.

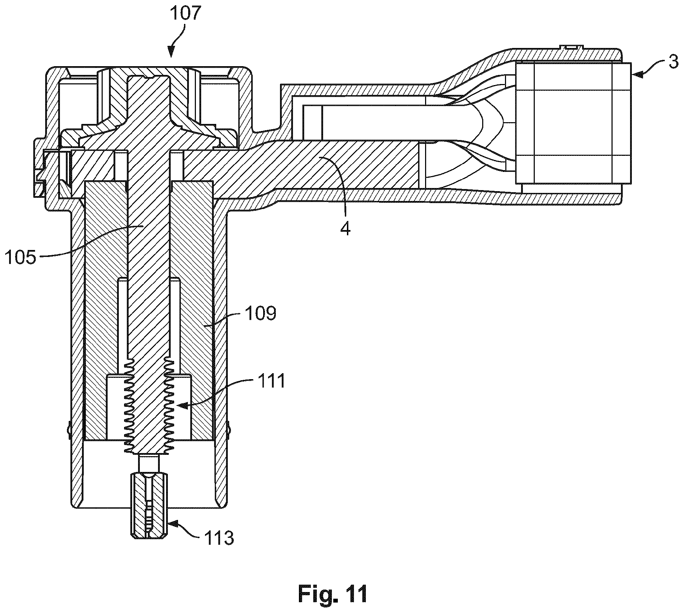

The heat retarding arrangement 2 can be configured as a screw 105 for interconnecting two electrical conductors 4. This type of connection, that is also known as bolted connection, is shown in Figures 11 to 13.

The screw 105 is configured to connect a conductor 4, which can be part of a cable 3, to another conductor (not shown). The screw 105 has a screw head 107 for driving the screw 105 and for pressing the conductor 4 against the other conductor. The screw head 107 is preferably electrically insulated for providing touch protection.

Between the conductor 4 and the other conductor, one or more intermediate pieces 109, such as a sleeve or a bushing, may be arranged. In order to produce a pressing force and to fixate the screw 105, the screw 105 is provided with a screw thread 111 at an end that is opposite to the screw head 107.

At the end of the screw 105 that is provided with the screw thread 111, the screw 105 may further be provided with an electrically insulated tip 113. The insulated tip 113 may increase the safety when mounting the screw 105.

Typically, the screw 105 itself only plays a minor role for conducting a current. Instead, the screw 105 is intended to mechanically fixate the electrically conductive parts with each other. However, the screw 105 also heats up when being in contact with hot electrically conductive parts, such as the conductor 4 or the intermediate piece 109.

In order to reduce the heat in the screw 105 and the conductors, the screw 105 can be provided with at least one cavity 93. Inside the cavity 93, phase change material 27 can be arranged.

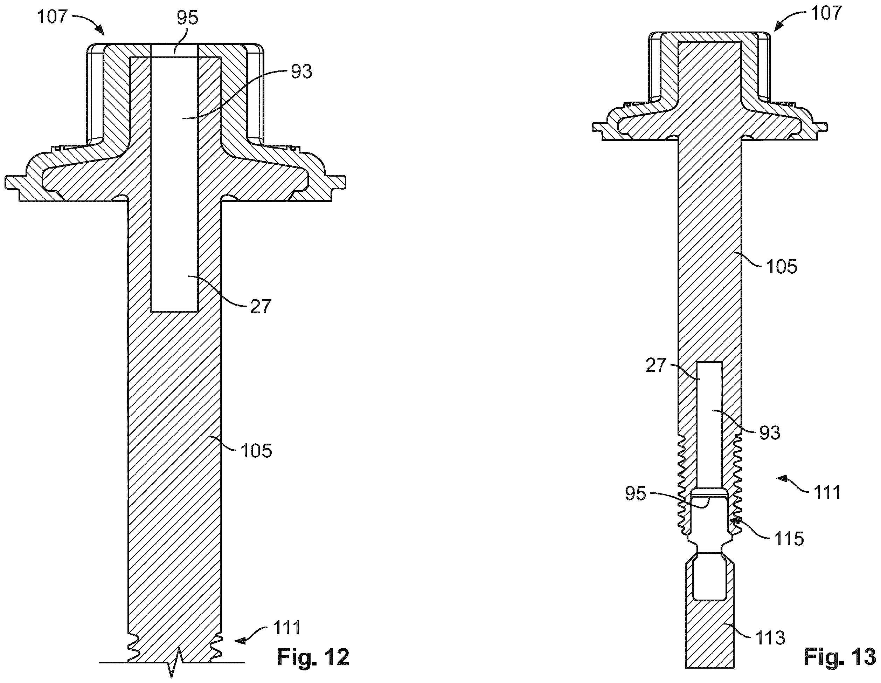

The cavity 93 for the phase change material 27 can be arranged at different positions in the screw 105. In the embodiment shown in Fig. 12, the cavity 93 is arranged close to the screw head 107. The cavity 93 can be formed during the manufacturing process of the screw 105 in the region of the screw head 107. Afterwards, the cavity 93 can be filled with phase change material 27. Finally, the cavity 93 can be closed with a cap 95 or other means.

In Fig. 13, an arrangement is shown that differs from the arrangement described above with respect to Fig. 12. Here, the cavity 93 extends at the opposite end of the screw 105. The cavity 93 opens from the tip of the screw 105 into the material of the screw 105, thus extending in the region of the screw thread 111.

The cavity 93 may be formed during manufacturing of the screw 105 when an opening 115 for receiving parts of the insulated tip 113 is formed. After forming the opening 115 and the cavity 93, the cavity 93 may be filled with phase change material 27.

The cavity 93 may be closed with a cap 95. Afterwards, the insulating tip 113 can be inserted into the opening 115 in order to fixate the same to the screw 105. In the alternative, the cap 95 may be omitted if the insulated tip 113 is sufficient for closing the cavity 93 when arranged inside the opening 115.

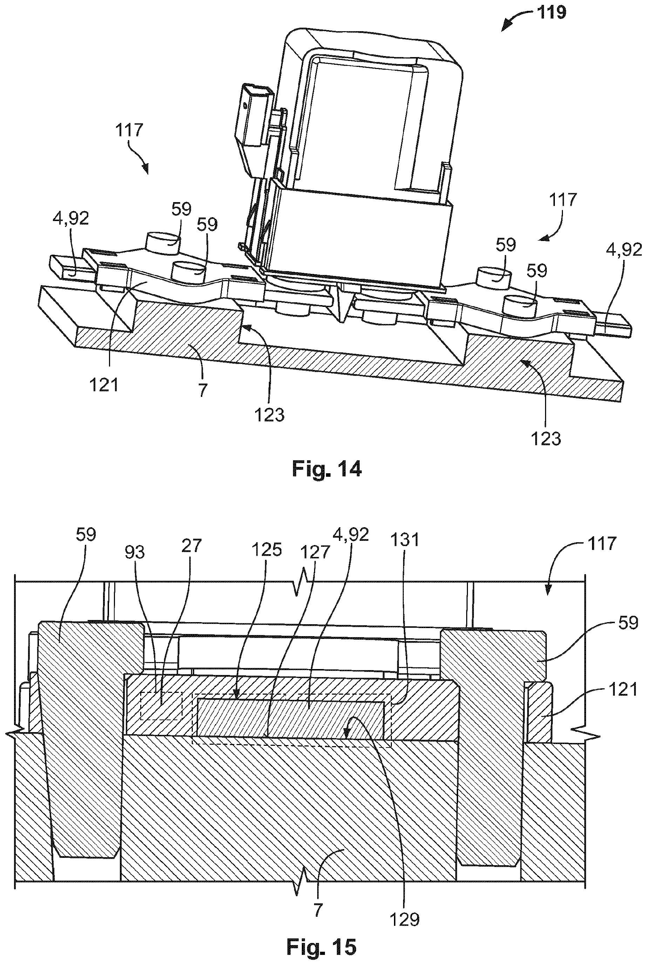

In the following, further arrangements are described that can benefit from the advantages of the heat retarding arrangement 2 according to the invention. In the following, a heat transfer arrangement 117 is described with respect to figures 14 and 15.

In figure 14, two heat transfer arrangements 117 are shown. For the sake of brevity, only one of the heat transfer arrangements 117 is described in the following. Just by way of example, the bus bars 92 shown in Fig. 14 can be connected to a relay 119.

The heat transfer arrangement 117 is intended to connect a conductor 4, in particular a bus bar 92, to a solid structure, in particular to a part 7 of a vehicle 5.

The heat transfer arrangement is intended to connect the bus bar 92 in an electrically insulating manner to the part 7, but , at the same time, to allow heat to be transferred from the bus bar 92 to part 7.

The heat transfer arrangement 117 comprises a hold down device 121 that can be arranged on top of the bus bar 92 and to receive the bus bar 92 at least in parts. The term "on top" refers to a side of the bus bar 92 that is opposite to the part 7, to which the bus bar 92 is attached by the arrangement 117.

In order to improve the connection between the hold down device 121 and part 7 of the vehicle, a protrusion 123 can be formed in part 7 as a counterpart to the hold down device 121.

The bus bar 92 can be arranged on top of the protrusion 123. The hold down device 121 can be arranged on top of the bus bar 9. Thereby, the nus bar 92 can be received between the protrusion 123 and the hold down device 121.

The hold down device 121 is preferably provided with a receptacle 125 for receiving the bus bar 92 in a way that leaves only one side 127 of the bus bar open for being in contact to part 7.

The hold down device 121 is preferably fixated via screws 59 to part 7. In order to electrically insulate the bus bar 92 form part 7, an intermediate layer 129 is preferably arranged between the bus bar 92 and part 7.

The intermediate layer 129 is preferably an electrically insulating material with a high thermal conductivity. The intermediate layer 129 may be formed as a plate between the bus bar 92 and part 7, as a foil, which is at least partially wrapped around the bus bar 92 or as a coating on the surface of the bus bar 92.

Just by way of example, a foil 131 is indicated by dashed lines in Fig 15, the foil 131 extending around the circumference of the bus bar 92. The foil 131 does not necessarily need to cover the whole surface of the bus bar 92. This is shown in Fig 15, where a region on top of the bus bar 92 is not covered by the foil 131.

In the arrangement described above, the hold down device 121 can comprise phase change material 27. However, this is not mandatory.

Just by way of example, a cavity 93 containing phase change material 27 is shown in the cross-sectional view of Fig. 15, As already mentioned, this is only optional. The phase change material 27 may improve the heat transfer away from the bus bar 92, in particular at those sections of the bus bar 92 that are not in direct contact with part 7.

Subsequently, the heat may be transferred by the hold down device 121 to part 7. Additionally or in the alternative, the intermediate layer 129 may comprise or may be made of phase change material 27. As a further alternative, a further layer (not shown) may be provided between the bus bar 92 and part 7 that provides phase change material 27 for heat retardation.

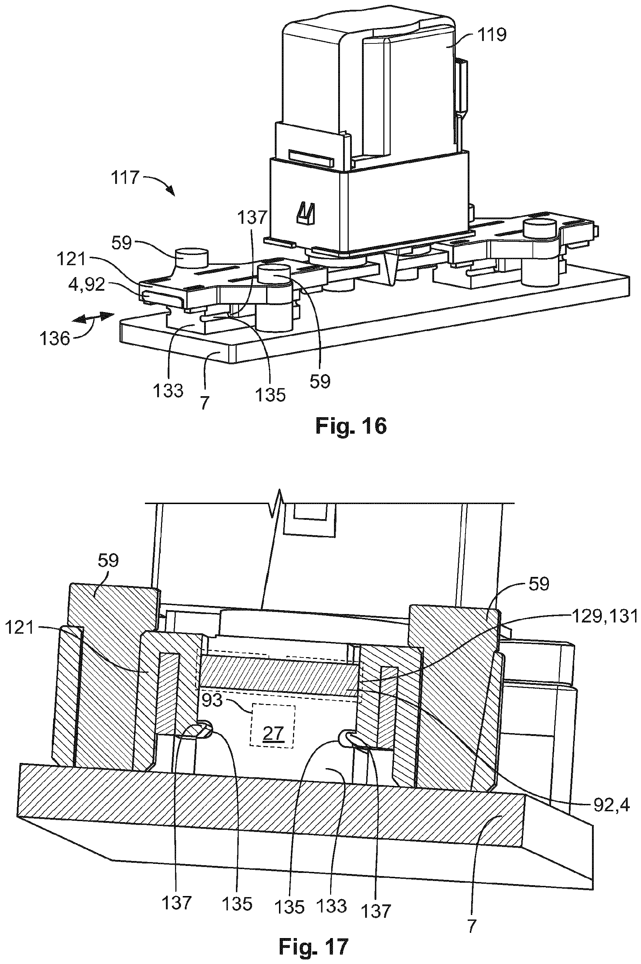

In the following, a second embodiment of the heat transfer arrangement 117 is described with respect to Figs. 16 and 17. For the sake of brevity, only the differences to the embodiment described with respect to Figs. 14 and 15 are described.

The second embodiment of the heat transfer arrangement 117 can be advantageous in a case, in which a part 7 is not provided with a protrusion 123.

In order to allow the bus bar 92 to be connected to part 7 in a satisfactory manner, namely heat conducting, but electrically insulating, the heat transfer arrangement 117 comprises an adapter 133 that may serve for the same purpose as the protrusion 123 described with respect to the first embodiment. The bus bar 92 is arranged between the hold down device 121 and the adapter 133.

In order to fixate the hold down device 121 and the adapter 133 to each other, the adapter 133 may be provided with latching grooves 135 on two opposing sides for receiving latching hooks 137 of the hold down device 121. The latching grooves 135 preferably extend parallel with a longitudinal direction 136 of the bus bar 92.

The adapter 133 may be made of an electrically insulating material. However, this is not mandatory. The adapter 133 may be made from a metal material, in particular aluminum, in order to improve the heat transfer from the bus bar 92 to part 7.

In particular in a case in which the adapter 133 is made of a metal, an intermediate layer 129 is preferably provided between the bus bar 92 and the adapter 133. The intermediate layer 129 preferably is a foil 131 wrapped around the bus bar 92.

As also in the first embodiment, the second embodiment of the heat transfer arrangement 117 may be provided with a phase change material 27. As already mentioned above, the hold down device 121 and/or the intermediate layer 129 may be provided with phase change material 27 (not shown). Furthermore, the adapter 133 may provided with phase change material 27, in particular inside at least one cavity 93 formed in the adapter 133 (indicated by dashed lines in Fig. 17.

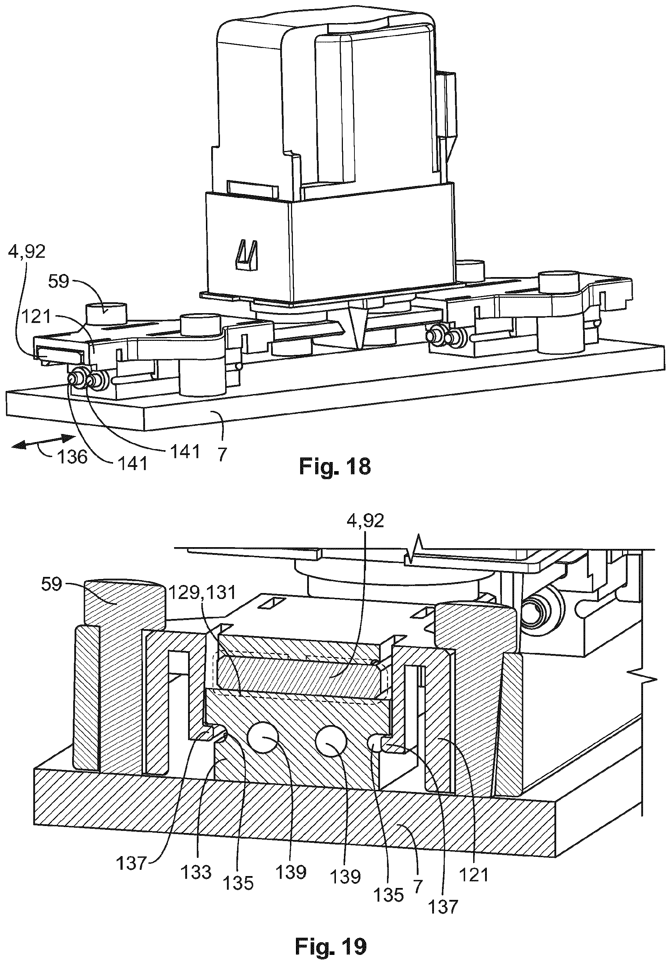

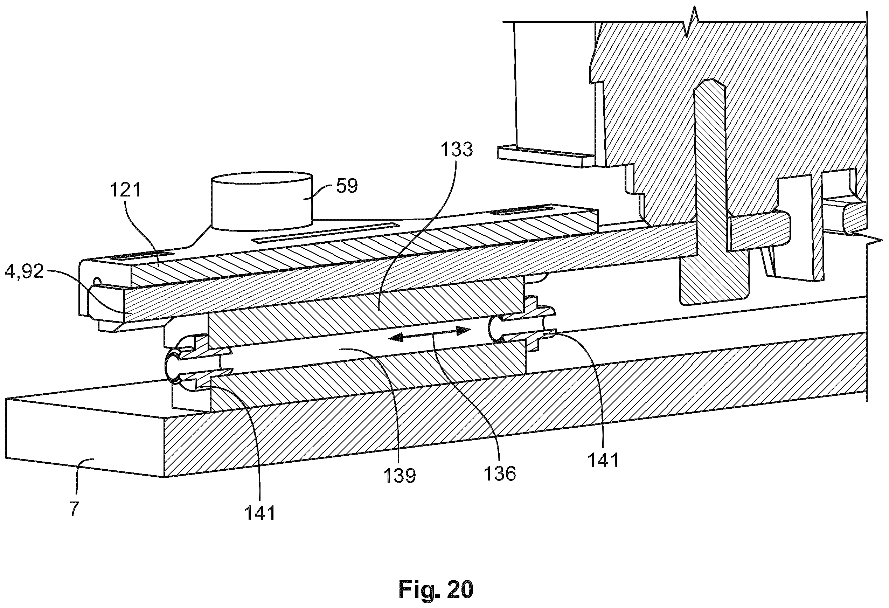

Now, reference is made to Figs. 18 to 20, in which a third embodiment of a heat transfer arrangement 117 is shown. Again, only the differences to the embodiments shown before are described in detail.

The third embodiment of the heat transfer arrangement 117 is basically similar to the second embodiment except for two cooling channels 139 extending through the adapter 133.

The cooling channels 139 preferably extend parallel with a longitudinal direction 136 of the bus bar 92. The cooling channels 139 can be used for actively cooling the adapters 133. To do so, the cooling channels 139 may be part of a cooling circuit through which a coolant flows in order to transfer heat away from the adapter 133.

At the ends of the cooling channels 139, connecting pieces 141 can be provided for facilitating the connection of the cooling channels 139 to other parts of a cooling circuit, such as tubes.

The third embodiment of the heat transfer arrangement 119 may optionally be provided with phase change material 27 (not shown).

### REFERENCE NUMERALS

- 1: cable clip
- 2: heat retarding arrangement
- 3: cable
- 4: electric conductor
- 5: vehicle
- 7: part of the vehicle
- 9: component
- 11: pin-and-socket connection
- 13: distance
- 15: cable receiving section
- 17: passage opening
- 19: abutment section
- 21: abutment surface
- 23: cross-sectional area
- 25: heat accumulator body
- 27: phase change material
- 29: cavities
- 31: frame structure
- 33: half bowl
- 35: half bowl
- 37: housing
- 39: cooling structure
- 41: cooling fin
- 43: locking hook
- 45: locking recess
- 47: recess
- 49: recess
- 51: fastening element
- 53: flange
- 55: passage bore
- 57: heat conducting element
- 58: further heat conducting element
- 59: fastening element
- 61: locking hook
- 63: passage openings
- 64: arrangement
- 65: thickened end
- 66: arrangement
- 67: inner conductor
- 69: inner insulation
- 70: section
- 71: shield
- 73: outer insulation
- 75: arrangement
- 77: temperature sensor
- 79: control unit
- 81: arrangement
- 83: charging port
- 87: arrangement
- 89: arrangement
- 90: contact element
- 91: receptacle
- 92: bus bar
- 93: cavity
- 95: cap
- 97: wall
- 99: cavity
- 101: arrangement
- 103: interior
- 105: screw
- 107: screw head
- 109: intermediate piece
- 111: screw thread
- 113: insulated tip
- 115: opening
- 117: heat transfer arrangement
- 119: relay
- 121: hold down device
- 123: protrusion
- 125: receptacle
- 127: side
- 129: intermediate layer
- 131: foil
- 133: adapter
- 135: latching grooves
- 136: longitudinal direction
- 137: latching hooks
- 139: cooling channels
- 141: connecting pieces

## Claims

1. Heat retarding arrangement (2) for passively cooling an electric conductor (3, 4) at or in an electric vehicle (5), wherein the heat retarding arrangement (2) comprises at least one phase change material (27) and is configured to be attachable at or in the electric conductor (4).

2. Heat retarding arrangement (2) according to claim 1, wherein the heat retarding arrangement (2) furthermore comprises a housing (37) in which the phase change material (27) is accommodated.

3. Heat retarding arrangement (2) according to claim 2, wherein the housing (37) is made of a plastic, a composite material, a silicone material and/or a metal.

4. Heat retarding arrangement (2) according to claim 2 or 3, wherein the housing (37) is expandable in a rubbery-elastic manner.

5. Heat retarding arrangement (2) according to one of claims 1 to 4, wherein the heat retarding arrangement (2) includes a heat accumulator body (25) with spaces (29) containing the phase change material (27).

6. Heat retarding arrangement (2) according to one of claims 1 to 5, wherein the heat retarding arrangement (2) is provided with at least one passive cooling structure (39).

7. Heat retarding arrangement (2) according to one of claims 1 to 6, wherein the heat retarding arrangement (2) includes at least one heat conducting element (57, 58) for abutment against the electric conductor (4), against a cable (3) including an electric conductor (4), or against a part (7) of the vehicle (5).

8. Heat retarding arrangement (2) according to one of claims 1 to 7, wherein the heat retarding arrangement (2) furthermore comprises at least one temperature sensor (77).

9. Heat retarding arrangement (2) according to one of claims 1 to 8, wherein the phase change material (27) contains sodium and/or paraffin.

10. Heat retarding arrangement (2) according to one of claims 1 to 9, wherein the heat retarding arrangement (2) is configured as a cable clip (1) for fastening a cable (3) including an electric conductor (4) at an electric vehicle (5), wherein the cable clip (1) comprises a cable receiving section (15) configured to receive the cable (3) and an abutment section (19) configured for the abutment against a part (7) of the vehicle (5), and wherein the cable clip (1) furthermore comprises at least one heat accumulator body (25) with the phase change material (27) which is configured to conduct heat from the cable receiving section (15) to the abutment section (19).

11. Arrangement (75), comprising a heat retarding arrangement (2) according to claim 8 and at least one control unit (79) connected with the at least one temperature sensor (77) in a data transmitting manner and configured to control a current flow.

12. Arrangement (81), comprising a heat retarding arrangement (2) according to one of claims 1 to 10, a charging port (83) on the vehicle side, and at least one cable (3) connected to the charging port (83) and including an electric conductor (4), wherein the heat retarding arrangement (2) is attached to the cable (3) at a distance (13) of less than 20 cm to the charging port (83).

13. Arrangement (89), comprising a heat retarding arrangement (2) according to one of claims 2 to 10 and at least one electric conductor (4), wherein the electric conductor (4) is provided with a receptacle (91), in which at least a portion of the phase change material (27) is accommodated and which extends into the conductor (4), and wherein the receptacle (91) is closed by the housing (37).

14. Arrangement (66), comprising a cable clip (1) according to claim 10 and at least one cable (3) received in the cable receiving section (15), wherein the at least one cable (3) has an inner conductor (4, 67), an inner insulation (69) surrounding the inner conductor (4, 67), a shield (71) surrounding the inner insulation (69), and an outer insulation (73) surrounding the shield (71), wherein the shield (71) is exposed in a section (70) of the cable (3), and the heat accumulator body (25) of the cable clip (1) abuts against the shield (71) in this section (70).

15. Arrangement (87), comprising a cable clip (1) according to claim 10, a part (7) of a vehicle (5), and at least one cable (3) of the vehicle (5) including an electric conductor (4), wherein the cable clip (1) is fixed to the part (7) of the vehicle (5) and abuts against the part (7) of the vehicle (5) with its abutment section (19), and wherein the at least one cable (3) of the vehicle (5) is received in the cable receiving section (15) of the cable clip (1).
